# EUROPEAN PATENT APPLICATION

(11) **EP 1 746 639 A1**
(43) Date of publication of application: **24.01.2007**
(21) Application number: 06014582.8
(22) Date of filing: 13.07.2006
(51) Int. Cl.: H01L 21/306, H01L 21/00

(54) **Wet etching method of single wafer**

(30) Priority: 19.07.2005 JP 2005208803
(71) Applicant: SUMCO CORPORATION, Minato-ku, Tokyo (JP)
(72) Inventor: Koyata, Sakae, c/o Sumco Corporation, Tokyo (JP); Hashii, Tomohiro, c/o Sumco Corporation, Tokyo (JP); Murayama, Katsuhiko, c/o Sumco Corporation, Tokyo (JP); Takaishi, Kazuhige, c/o Sumco Corporation, Tokyo (JP); Katoh, Takeo, c/o Sumco Corporation, Tokyo (JP)
(74) Representative: Albrecht, Thomas

(57) **Abstract**

Local shape collapse of a wafer end portion is suppressed to the minimum level, and a wafer front surface as well as a wafer end portion is uniformly etched while preventing an etchant from flowing to a wafer rear surface.

There is provided an etching method of a single wafer which supplies an etchant onto a wafer front surface in a state where a single wafer having flattened front and rear surfaces is held, and etches the wafer front surface and a front surface side end portion by using a centrifugal force generated by horizontally rotating the wafer. According to this method, the etchant is intermittently supplied onto the front surface of the wafer in twice or more, supply of the etchant is stopped after the etchant for one process is supplied, and the etchant for the next process is supplied after the supplied etchant flows off from the end portion of the wafer.

## Description

### BACKGROUND OF THE INVENTION

### 1. Field of the Invention

The present invention relates to an etching method of a single wafer which can uniformly etch not only a wafer front surface but also a wafer end portion while suppressing local shape collapse of the wafer end portion to the minimum level.

### 2. Description of the Related Art

Generally, a semiconductor wafer manufacturing process is constituted of steps of subjecting a wafer obtained by cutting and slicing a single-crystal ingot to chamfering, machine polishing (lapping), etching, mirror grinding (polishing) and cleaning, and produces a wafer having a highly accurate degree of flatness. The wafer subjected to machining processes such as block cutting, external-diameter grinding, slicing, lapping and others has a damage layer, i.e., a work-affected layer on a surface thereof. The work-affected layer induces a crystal defect such as slip dislocation in a device manufacturing process, reduces a mechanical strength of the wafer and adversely affects electrical characteristics, and hence this layer must be completely removed. Etching is carried out in order to remove this work-affected layer. As etching, dip etching or single wafer etching is performed.

Of these types of etching, single wafer etching has been examined as an optimum etching method since it can control surface roughness and a texture size of a wafer having an increased hole diameter. Single wafer etching is a method which drops an etchant onto a flattened surface of a single wafer and horizontally rotates (spins) the wafer to spread the dropped etchant on the entire wafer surface, thereby effecting etching. The etchant supplied to the wafer surface spreads on the entire wafer surface from a position to which the etchant has been supplied and reaches an end portion on the wafer front surface side by a centrifugal force generated by horizontally rotating the wafer. Therefore, the end portion on the wafer front surface side as well as the wafer front surface is etched at the same time. The most part of the supplied etchant blows about from the wafer front surface side end portion by the centrifugal force to be collected in a cup or the like provided in an etching apparatus. However, a part of the etchant flows to a wafer rear surface side end portion and a wafer rear surface from the wafer front surface side end portion so that the wafer rear surface side end portion and the wafer rear surface are disadvantageously etched.

As a countermeasure for such an inconvenience, there has been disclosed a single wafer processing mechanism comprising: a rotation driving portion, a rotation base which has a central shaft connected with the rotation driving portion and also has positioning portions at peripheral positions in order to mount a processing target on a predetermined position; a holding member which holds an end surface of the processing target provided between the positioning portions at the periphery of the rotation base; and a processing nozzle which is provided above the rotation base and to which a material corresponding to processing for the processing target is supplied, wherein a protruding height X mm of the positioning portions and the holding member from a contact position of the rotation base on a rear surface of the processing target is 0 < X < A+0.5 mm where A mm is a thickness of an end surface of the processing target (see, e.g., Patent Reference 1). Further, in Patent Reference 1, there is proposed a structure which comprises: a gas supply block provided around the central shaft of the rotation base in a lower portion thereof; and a supply opening which pierces the inside of the rotation base and to which a gas from the block is supplied, and increases an atmospheric pressure in a space between the rotation base and a rear surface of the processing target. In the single wafer processing mechanism disclosed in this Patent Reference 1, when the protruding height of the positioning portions and the holding member is configured to have the above-described ratio, an air turbulence or ricochet of the processing liquid can be suppressed during high-speed rotation of the processing target. Furthermore, supplying a gas from the supply opening provided in the block can prevent the processing liquid such as an etchant from flowing to the rear surface of the processing target.

[Patent Reference 1] Japanese Unexamined Patent Application Publication No. 289002-1999 (claims 1 and 2, paragraphs [0010] and [0025])

However, in the single wafer processing mechanism disclosed in Patent Reference 1, a staying time of the processing liquid at the wafer end portion is prolonged when a gas is supplied from a lower side of the processing target in order to avoid flowing of the processing liquid. Therefore, when the processing liquid is an etchant, there is a problem that a position where the etchant stays is etched beyond necessity and a shape of the wafer end portion subjected to a chamfering process locally collapses.

### SUMMARY OF THE INVENTION

It is an object of the present invention to provide an etching method of a single wafer which can prevent an etchant from flowing to a wafer rear surface and uniformly etch not only a wafer front surface but also a wafer end portion while suppressing local shape collapse of the wafer end portion to the minimum level.

According to the invention defined in claim 1, there is provided an improvement in an etching method of a single wafer which supplies an etchant onto a front surface of a single wafer in a state where the wafer having flattened front and rear surfaces is held, and etches the wafer front surface and a wafer front surface side end portion by using a centrifugal force generated by horizontally rotating the wafer.

Its characteristic configuration lies in that the etchant is intermittently supplied to the front surface of the wafer in twice or more, supply of the etchant is stopped after supplying the etchant for one process, and the etchant for the next process is supplied after the supplied etchant flows off from the end portion of the wafer.

In the invention according to claim 1, an etching width taken by the etchant supplied for one process is reduced by intermittently supplying the etchant. After the etchant for one process is supplied, supply of the etchant is stopped, and the etchant for the next process is supplied after the supplied etchant flows off from the end portion of the wafer. Therefore, local shape collapse due to the etchant staying at the wafer end portion can be suppressed to the minimum level, and not only the wafer front surface but also the wafer end portion can be uniformly etched while preventing the etchant from flowing to the wafer rear surface. Moreover, since the etchant is intermittently supplied in the predetermined number of times, a desired etching width can be assured.

According to the invention defined in claim 2, there is provided the invention set forth in claim 1 as the method in which the wafer is a silicon wafer having a chamfered end portion.

According to the invention defined in claim 3, there is provided the invention set forth in claim 1 as the method in which the wafer is held by vacuum-sucking the wafer rear surface by using a chuck.

According to the invention defined in claim 4, there is provided the invention set forth in claim 1 as the method in which a gas is supplied toward a rear surface side end portion from a position between the wafer rear surface and the rear surface side end portion during etching, thereby preventing the etchant from flowing to the wafer rear surface.

According to the invention defined in claim 5, there is provided the invention set forth in claim 1 as the method in which the etchant is an acid etching liquid.

According to the etching method of a single wafer of the present invention, the etchant is intermittently supplied onto the front surface of the wafer in twice or more, supply of the etchant is stopped after the etchant for one process is supplied, and the etchant for the next process is supplied after the supplied etchant flows off from the end portion of the wafer. As a result, local shape collapse of the wafer end portion is suppressed to the minimum level, and not only the wafer front surface but also the wafer end portion can be uniformly etched while preventing the etchant from flowing to the wafer rear surface.

### BRIEF DESCRIPTION OF THE DRAWINGS

FIG. 1 is a view showing an etching apparatus of a single wafer;
FIG. 2 is an explanatory view showing a shape of a chamfered wafer end portion;
FIG. 3 is a view showing a chamfer width A₁ on a wafer front surface side in each of Example 1 and Comparative Examples 1 and 2;
FIG. 4 is a view showing a chamfer width A₂ on a wafer rear surface side in each of Example 1 and Comparative Examples 1 and 2;
FIG. 5 is a view showing a curvature radius R of a wafer end portion in each of Example 1 and Comparative Examples 1 and 2;
FIG. 6 is a cross-sectional view showing a shape of the wafer end portion before performing single wafer etching according to Example 1;
FIG. 7 is a cross-sectional view showing a shape of the wafer end portion according to Example 1;
FIG. 8 is a cross-sectional view showing a shape of a wafer end portion according to Comparative Example 1; and
FIG. 9 is a cross-sectional view showing a shape of a wafer end portion according to Comparative Example 2.

### DETAILED DESCRIPTION OF THE PREFERRED EMBODIMENT

The best mode for carrying out the present invention will now be described with reference to the accompanying drawings.

An etching method of a single wafer according to the present invention is an improvement in an etching method of a single wafer which supplies an etchant onto a front surface of a single wafer having flattened front and rear surfaces in a state where the wafer is held and etches the wafer front surface and a wafer end portion by using a centrifugal force generated by horizontally rotating the wafer. Its characteristic configuration lies in that the etchant is intermittently supplied onto the front surface of the wafer twice or more, or preferably, two to five times, supply of the etchant is stopped after the etchant for one process is supplied, and the etchant for the next process is supplied after the supplied etchant flows off from the end portion of the wafer.

An etching width taken by the etchant supplied for one process is reduced by intermittently supplying the etchant, supply of the etchant is stopped after the etchant for one process is supplied, and the etchant for the next process is supplied after the supplied etchant flows off from the end portion of the wafer. Therefore, local shape collapse due to the etchant staying at the wafer end portion can be suppressed to the minimum level, and not only the wafer front surface but also the wafer end portion can be uniformly etched while preventing the etchant from flowing to the wafer rear surface. Additionally, since the etchant is intermittently supplied in the predetermined number of times, a desired etching width can be assured.

It is preferable to stop supply of the etchant for one process, and then supply the etchant for the next process after an interval of 10 to 15 seconds until the supplied etchant flows off from the end portion of the wafer. It is preferable for an etchant supply amount and a supply time for each process to be uniform. For example, assuming that a width of all etching processes is 15 µm, in case of performing intermittent supply in five times in total, an etchant supply amount and a supply time are controlled in such a manner that a width of etching for one process becomes 3 µm.

In the etching method according to the present invention, it is preferable to use a silicon wafer having a chamfered end portion as a target wafer. Further, in the etching method according to the present invention, the wafer may be held by vacuum-sucking the wafer rear surface by using a chuck. Furthermore, in the etching method according to the present invention, a gas may be supplied toward a rear surface side end portion from a position between the wafer rear surface and the rear surface side end portion during etching, thereby preventing the etchant from flowing to the wafer rear surface. Any type of etchant to be supplied can be applied to the method according to the present invention, but an acid etching liquid is preferable, and an etchant containing HF, HNO₃, H₃PO₄ and H₂O at a predetermined ratio is particularly preferable. An etchant containing HF, HNO₃, H₃PO₄ and H₂O at a mixture weight ratio of 7.0%:31.7%:34.6%:26.7% is more preferable.

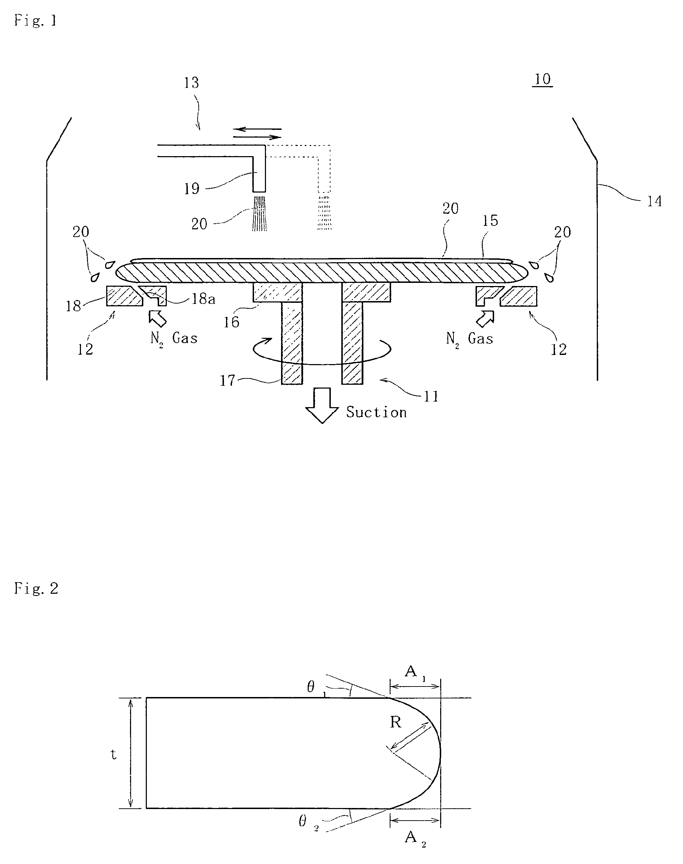

The etching method according to the present invention is carried out by using such a single wafer etching apparatus 10 as shown in FIG. 1. This etching apparatus 10 is provided with wafer rotating means 11, flowing preventing means 12, etchant supplying means 13 and a cup 14. The wafer rotating means 11 is constituted of a chuck 16 which sucks a rear surface of a wafer 15 by vacuum suction to horizontally hold the wafer 15, and a rotation driving portion 17 which is integrally provided at a lower portion of this chuck 16 and horizontally rotates the wafer 15. The flowing preventing means 12 is constituted of a cylindrical block 18 concentrically provided with a gap between itself and the chuck 16, and a gas supply path 18a which pierces the inside of this cylindrical block 18 and through which a gas is supplied. The gas supply path 18a is formed to outwardly extend to a rear surface side end portion from a position between a wafer rear surface and the rear surface side end portion. As a gas to be supplied, there is a nitrogen gas or air. The etchant supplying means 13 is constituted of an etchant supply nozzle 19 which is provided above the wafer 15, a non-illustrated etchant supply pump and others. The etchant supply nozzle 19 can horizontally move as indicated by solid arrows in FIG. 1, and an etchant 20 is supplied onto an upper surface of the wafer 15 from this etchant supply nozzle 19. The cup 14 is provided to cover an outer side of the flowing preventing means 12, prevents the etchant 20 blown about by a centrifugal force from scattering toward the outside of the apparatus 10, and also collects the etchant 20.

The wafer 15 is mounted on the vacuum suction type chuck 16 of the thus configured single wafer etching apparatus 10 in such a manner that the front surface becomes the upper surface, and vacuum suction is carried out, thereby horizontally holding the wafer 15. Then, the wafer 15 is horizontally rotated by the rotation driving portion 17, and the etchant 20 is supplied onto the upper surface of the wafer 15 from the etchant supply nozzle 19 while horizontally moving the etchant supply nozzle 19 provided above the wafer 15 as indicated by the solid arrows in FIG. 1. In the etching method according to the present invention, this etchant 20 is intermittently supplied twice or more. Specifically, intermittent supply is carried out by adjusting a supply amount for one process in such a manner that a total supply amount to be intermittently supplied becomes substantially equal to a total supply amount of a conventional etching method which continuously supplies an etchant at a time.

The etchant 20 supplied to the upper surface of the wafer 15 gradually moves from a supplied position (e.g., in the vicinity of the center of the wafer front surface) to a wafer end portion side by a centrifugal force generated by horizontally rotating the wafer 15 while etching a work-affected layer on the wafer front surface. Further, the etchant 20 etches the wafer front surface side end portion, and scatters toward the outside of the wafer in the form of droplets to be collected by the cup 14. Furthermore, a gas is supplied toward the rear surface side end portion from a position between the wafer rear surface and the rear surface side end portion through the gas supply path 18a piercing the inside of the cylindrical block 18 so that a flow of the gas prevents a part of the etchant from flowing to the wafer rear surface from the wafer rear surface side end portion. After supply of the etchant for one process, supply of the etchant is temporarily stopped until the supplied etchant flows off from the end portion of the wafer. After the etchant completely flows off from the wafer end portion, the etchant for the next process is supplied.

As described above, an etching width taken by the etchant supplied for one process is reduced by intermittently supplying the etchant, supply of the etchant is stopped after the etchant for one process is supplied, and the etchant for the next process is supplied after the supplied etchant flows off from the end portion of the wafer. Therefore, local shape collapse due to the etchant staying at the wafer end portion can be suppressed to the minimum level. Moreover, not only the wafer front surface but also the wafer end portion can be uniformly etched while preventing the etchant from flowing to the wafer rear surface. Additionally, since the etchant is intermittently supplied in the predetermined number of times, a desired etching width can be assured.

An Example of the present invention and Comparative Examples will now be described in detail.

### <Example 1>

First, there was prepared a silicon wafer of 300 mmφ having a chamfered end portion and flattened front and rear surfaces. Further, there was also prepared an etchant containing HF, HNO₃, H₃PO₄ and H₂O at a mixture weight ratio of 7.0%:31.7%:34.6%:26.7%. FIG. 2 shows a cross-sectional shape of the chamfered wafer. In FIG. 2, reference character t denotes a thickness of the wafer; A₁, a chamfer width on a wafer front surface side; A₂, a chamfer width on a wafer rear surface side; R, a curvature radius of a wafer end portion; θ₁, a chamfer angle of a wafer front surface side end portion; and θ₂, a chamfer angle of a wafer rear surface side end portion.

Then, the wafer was mounted on a chuck of a single wafer etching apparatus shown in FIG. 1 in such a manner that the front surface becomes an upper surface. Subsequently, the wafer was horizontally rotated, the etchant was supplied onto the upper surface of the wafer from a supply nozzle provided above the wafer, and the etchant was spread on the wafer front surface to reach the wafer front surface side end portion by a centrifugal force generated by horizontal rotation, thereby etching a work-affected layer produced by flattening processing. Furthermore, a nitrogen gas was supplied toward the rear surface side end portion from a position between the wafer rear surface and the rear surface side end portion through a gas supply path piercing the inside of a cylindrical block so that a flow of this nitrogen gas can prevent a part of the etchant from flowing to the wafer rear surface from the wafer rear surface side end portion. In regard to supply of the etchant, a supply amount of the etchant was controlled in such a manner that an etching width for one process becomes approximately 3 µm, and supply of the etchant was stopped after supply of the etchant for one process. Upon elapse of an interval of 10 to 15 seconds, the etchant for the next process was supplied after the supplied etchant flowed off from the end portion of the wafer, and the etchant was intermittently supplied onto the front surface of the wafer in five times, thereby etching the front surface of the silicon wafer 15 µm in total.

### <Comparative Example 1>

Processes in this example are the same as those in Example 1 except that the etchant is continuously supplied, and the front surface of the silicon wafer was etched 15 µm in total.

### <Comparative Example 2>

Processes in this example are the same as those in Example 1 except that the etchant is continuously supplied and the gas is not supplied toward the rear surface side end portion from the position between the wafer rear surface and the rear surface side end portion through the gas supply path piercing the inside of the cylindrical block, and the front surface of the silicon wafer was etched 15 µm in total.

### <Comparative Test 1>

The chamfer width A₁ on the wafer front surface side, the chamfer width A₂ on the wafer rear surface side and the curvature radius R of the wafer end portion of the silicon wafer subjected to single wafer etching according to each of Example 1 and Comparative Examples 1 and 2 were measured at seven points at intervals of 45°. Additionally, the chamfer width A₁, the chamfer width A₂ and the curvature radius R of the silicon wafer before single wafer etching were likewise measured.

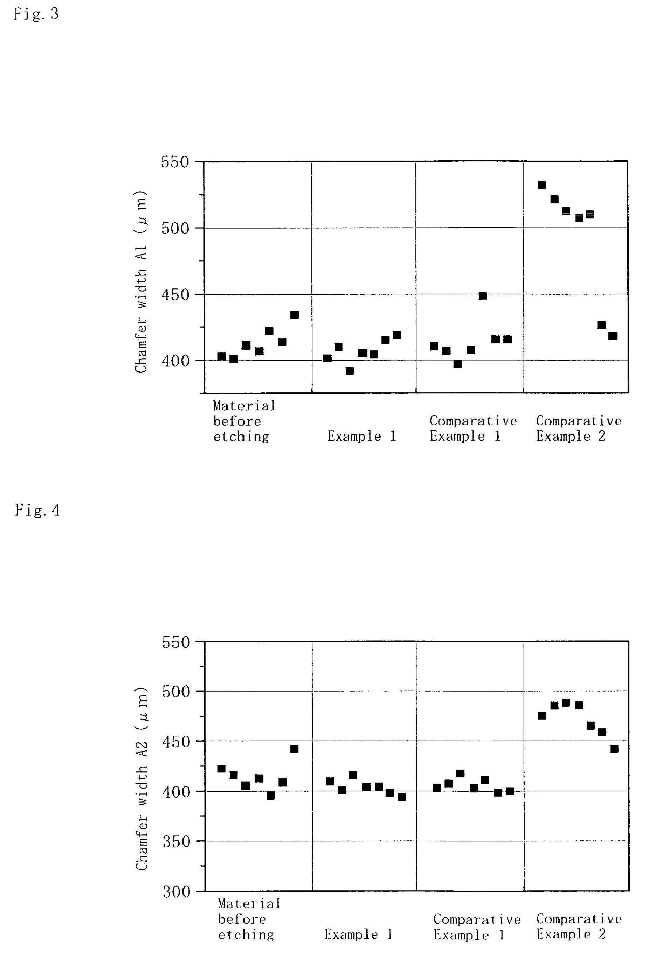

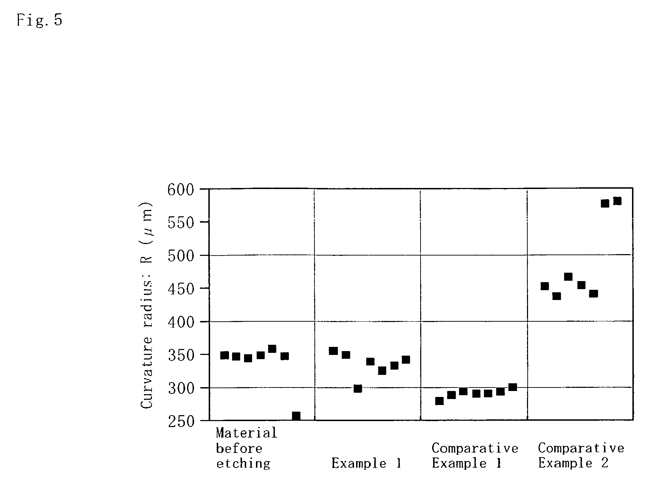

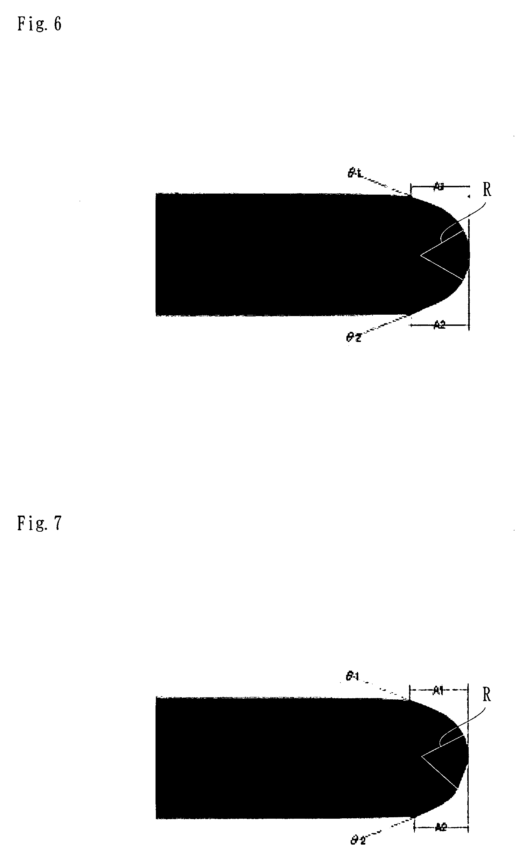

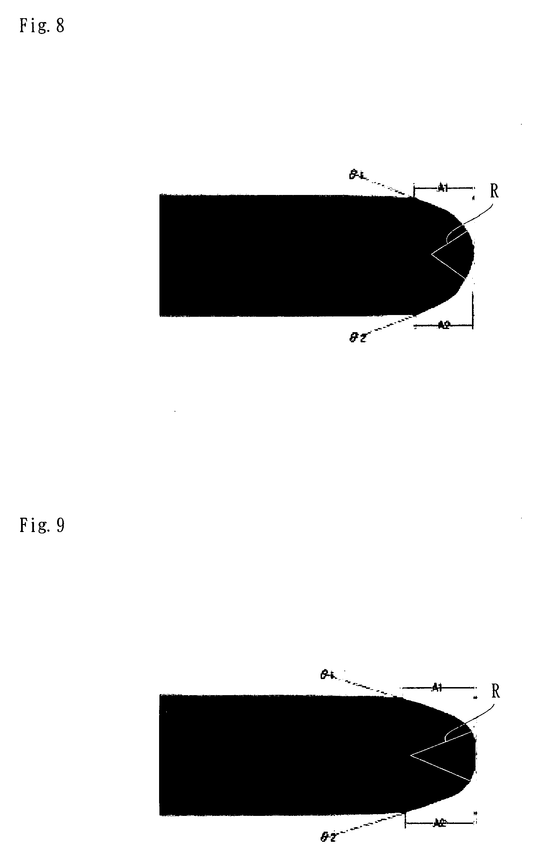

Table 1 shows measured values of the chamfer width A₁ on the wafer front surface side, Table 2 shows measured values of the chamfer width A₂ on the wafer rear surface side, Table 3 shows measured values of the curvature radius R of the wafer end portion, FIGS. 3 to 5 show measurement results of the chamfer width A₁ on the wafer front surface side, the chamfer width A₂ on the wafer rear surface side and the curvature radius R of the wafer end portion in each of Example 1 and Comparative Examples 1 and 2, and FIGS. 6 to 9 are a cross-sectional view showing a shape of the wafer end portion before performing single wafer etching and cross-sectional views showing shapes of the wafer end portion according to Example 1 and Comparative Examples 1 and 2, respectively.

**[Table 1]**

| | Average of chamfer width A₁ [µm] | Standard deviation [µm] |
|---|---|---|
| Material before etching | 413.000 | 11.5902 |
| Example 1 | 405.143 | 8.9336 |
| Comparative Example 1 | 413.429 | 16.0193 |
| Comparative Example 2 | 488.000 | 46.2358 |

**[Table 2]**

| | Average of chamfer width A₂ [µm] | Standard deviation [µm] |
|---|---|---|
| Material before etching | 412.714 | 15.5211 |
| Example 1 | 399.000 | 7.9582 |
| Comparative Example 1 | 401.857 | 7.0576 |
| Comparative Example 2 | 467.714 | 18.3913 |

**[Table 3]**

| | Average of curvature radius R [µm] | Standard deviation [µm] |
|---|---|---|
| Material before etching | 335.429 | 35.7158 |
| Example 1 | 334.000 | 18.4752 |
| Comparative Example 1 | 290.571 | 5.7404 |
| Comparative Example 2 | 485.000 | 62.5700 |

As apparent from Tables 1 to 3 and FIGS. 3 to 9, in Comparative Example 2 in which etching was performed without taking any measure for preventing the etchant from flowing to the wafer rear surface, all of the chamfer width A₁, the chamfer width A₂ and the curvature radius R of the wafer end portion have large fluctuation bands as compared with the material before etching which has been chamfered in a flattening process. Specifically, the measured values of the chamfer width A₁ and the chamfer width A₂ of the wafer end portion are respectively large. Further, although not shown in the measurement results, the chamfer angle θ₁ of the wafer front surface side end portion and the chamfer angle θ₂ of the wafer rear surface side end portion are respectively small, and the wafer end portion was greatly etched at a position close to the wafer front surface side and the wafer rear surface side. It can be understood from this result that the wafer end portion cannot be uniformly etched and a shape of the chamfered wafer end portion collapses on the whole when a measure for preventing the etchant from flowing is not taken like Comparative Example 2. Furthermore, in Comparative Example 1 in which etching was performed by supplying the etchant at a time, results of the chamfer width A₁ and the chamfer width A₂ are substantially the same as those in Example 1, but the curvature radius R alone greatly fluctuates, which leads to a result supporting the fact that the etchant stays in the vicinity of the center of the wafer end portion in a thickness direction for a predetermined period of time. On the other hand, Example 1 using the method according to the present invention has a result that all of the chamfer width A₁ and the chamfer width A₂ and the curvature radius R at the wafer end portion have small fluctuation bands. It was confirmed from this result that the wafer end portion can be uniformly etched while suppressing shape collapse of the wafer end portion to the minimum level by the method according to the present invention.

## Claims

1. An etching method of a single wafer, which supplies an etchant onto a front surface of a single wafer having flattened front and rear surfaces in a state where the wafer is held, and etches the wafer front surface and a wafer front surface side end portion by a centrifugal force generated by horizontally rotating the wafer,
the etching method comprising: intermittently supplying the etchant onto the front surface of the wafer in twice or more; stopping supply of the etchant after the etchant for one process is supplied; and supplying the etchant for the next process after the supplied etchant flows off from the end portion of the wafer.

2. The method according to claim 1, wherein the wafer is a silicon wafer having a chamfered end portion.

3. The method according to claim 1, wherein the wafer is held by vacuum-sucking the wafer rear surface by using a chuck.

4. The method according to claim 1, wherein a gas is supplied toward a rear surface side end portion from a position between the wafer rear surface and the rear surface side end portion during etching, thereby preventing the etchant from flowing to the wafer rear surface.

5. The method according to claim 1, wherein the etchant is an acid etching liquid.
